# EUROPÄISCHE PATENTSCHRIFT

(11) **EP 2 212 931 B1**
(45) Veröffentlichungstag und Bekanntmachung des Hinweises auf die Patenterteilung: **12.09.2018**
(21) Anmeldenummer: 08854645.2
(22) Anmeldetag: 13.11.2008
(51) Int. Cl.: H01L 33/32, H01L 33/04, H01L 33/14, H01S 5/343, H01S 5/323

(54) **LED MIT STROMAUFWEITUNGSSCHICHT**
LED HAVING CURRENT SPREADING LAYER
LED COMPORTANT UNE COUCHE DE DIFFUSION DE COURANT

(30) Priorität: 30.11.2007 DE 102007057674
(43) Veröffentlichungstag der Anmeldung: 04.08.2010
(73) Patentinhaber: OSRAM Opto Semiconductors GmbH, 93055 Regensburg (DE)
(72) Erfinder: SABATHIL, Matthias, 93059 Regensburg (DE); PETER, Matthias, 93087 Alteglofsheim (DE)
(74) Vertreter: Epping - Hermann - Fischer
(86) Internationale Anmeldenummer: PCT/DE2008/001882
(87) Internationale Veröffentlichungsnummer: WO 2009/067983

(56) Entgegenhaltungen:
- EP-A- 1 017 113
- JP-A- 11 251 684
- US-A1- 2004 004 223
- HEIKMAN STEN ET AL: "High conductivity modulation doped AlGaN/GaN multiple channel heterostructures" JOURNAL OF APPLIED PHYSICS, AMERICAN INSTITUTE OF PHYSICS. NEW YORK, US, Bd. 94, Nr. 8, 15. Oktober 2003 (2003-10-15), Seiten 5321-5325, XP012060421 ISSN: 0021-8979
- WEN T C ET AL: "NITRIDE-BASED LEDS WITH MODULATION-DOPED AL0.12GA0.88N-GAN SUPERLATTICE STRUCTURES" IEEE TRANSACTIONS ON ELECTRON DEVICES, IEEE SERVICE CENTER, PISACATAWAY, NJ, US, Bd. 51, Nr. 10, 1. Oktober 2004 (2004-10-01), Seiten 1743-1746, XP001211153 ISSN: 0018-9383

## Beschreibung

Die Erfindung betrifft eine LED mit einer Stromaufweitungsschicht gemäß Patentanspruch 1.

Bei herkömmlichen Licht emittierenden Dioden (LED) erfolgt die elektrische Kontaktierung in der Regel durch zwei elektrische Kontaktschichten, wobei oftmals nur ein vergleichsweise kleiner Bereich der Chipoberfläche mit einer Kontaktfläche versehen wird. Diese Art der Kontaktierung kann nachteilig zu einer inhomogenen Bestromung des Halbleiterchips führen, die zu einer erhöhten Vorwärtsspannung und zu einer geringen Quanteneffizienz in der aktiven Zone führt. Dieser Effekt tritt insbesondere bei Halbleitermaterialien auf, die eine geringe Querleitfähigkeit aufweisen, insbesondere bei Nitridverbindungshalbleitern. Die Druckschrift S. Heikman, S. Keller, D. S. Green, S. P. DenBaars, "High conductivity modulation doped AlGaN/GaN multiple channel heterostructures", J. Appl. Phys. 94 (2003), 5321-5325, beschreibt eine LED, die ein Übergitter aufweist, wobei das Übergitter eine Stromaufweitungsschicht sein kann. Das Übergitter weist eine sich mehrfach wiederholende Schichtfolge auf, wobei die Schichtfolge eine GaN-Schicht, eine AlGaN:Si-Schicht und eine AlGaN-Schicht aufweist. Die AlGaN:Si-Schicht weist einen Konzentrationsgradienten des Al-Gehalts von 22 % bis 0 % auf.

Der Erfindung liegt die Aufgabe zugrunde, eine LED mit einer verbesserten Stromaufweitungsstruktur anzugeben, die sich insbesondere durch eine verbesserte Querleitfähigkeit und einen verbesserten vertikalen Stromtransport auszeichnet.

Diese Aufgabe wird durch eine LED mit den Merkmalen des Patentanspruchs 1 gelöst. Vorteilhafte Ausgestaltungen und Weiterbildungen der Erfindung sind Gegenstand der abhängigen Ansprüche.

Erfindungsgemäß ist eine LED, die eine strahlungsemittierende aktive Schicht, einen n-Kontakt, einen p-Kontakt und eine Stromaufweitungsschicht aufweist, vorgesehen. Die Stromaufweitungsschicht ist zwischen der aktiven Schicht und dem n-Kontakt angeordnet. Ferner weist die Stromaufweitungsschicht eine sich mehrfach wiederholende Schichtfolge auf. Die Schichtfolge weist eine erste n-dotierte Schicht, eine undotierte Schicht und eine Schicht aus AlₓGa₁₋ₓN, mit 0 < x < 1, auf, wobei die Schicht aus AlₓGa₁₋ₓN einen Konzentrationsgradienten des Al-Gehalts aufweist. Die Schicht aus AlₓGa₁₋ₓN ist zwischen der undotierten Schicht und der n-dotierten Schicht angeordnet.

In der Stromaufweitungsschicht, die eine sich mehrfach wiederholende Schichtfolge aufweist, bildet sich an der Grenzfläche zwischen der undotierten Schicht und der Schicht aus AlₓGa₁₋ₓN ein zweidimensionales Elektronengas aus. Durch die Ausbildung eines zweidimensionalen Elektronengases erhöht sich mit Vorteil die Querleitfähigkeit der Stromaufweitungsschicht. Die erhöhte Querleitfähigkeit der Stromaufweitungsschicht führt zu einer homogenen Bestromung der aktiven Schicht und erhöht dadurch vorteilhaft die Effizienz der LED.
Der Konzentrationsgradient des Aluminiumgehalts der Schicht aus AlₓGa₁₋ₓN verbessert den vertikalen Stromtransport in der Stromaufweitungsschicht. Ferner vermindern sich dadurch Verspannungen an der Grenzfläche zwischen den einzelnen Schichten. Das führt zu einer reduzierten Degradation der LED, wodurch sich die Langzeitstabilität und die Lebensdauer der LED mit Vorteil erhöht.
Durch die Zusammensetzung der Stromaufweitungsschicht wird somit sowohl eine hohe Querleitfähigkeit durch das Ausbilden eines zweidimensionalen Elektronengases an der Grenzfläche zwischen der undotierten Schicht und der AlₓGa₁₋ₓN-Schicht erzeugt. Weiterhin wird eine Optimierung des vertikalen Stromtransports in der Stromaufweitungsschicht durch den Konzentrationsgradienten des Aluminiumgehalts der Schicht aus AlₓGa₁₋ₓN erzielt.
Die Licht emittierende Diode (LED) ist vorzugsweise als Dünnfilm-LED ausgeführt. Bei einer Dünnfilm-LED ist das Herstellungssubstrat, auf dem der Schichtstapel für die LED hergestellt, insbesondere abgeschieden wurde, bereichsweise oder vollständig entfernt. Das Herstellungssubstrat ist vorzugsweise das Aufwachssubstrat, auf dem der Schichtstapel epitaktisch aufgewachsen ist.
Ein Grundprinzip eines Dünnschicht-Leuchtdiodenchips ist beispielsweise in I. Schnitzer et al., Appl. Phys. Lett. 63 (16), 18. Oktober 1993, 2174 - 2176 beschrieben.

Bevorzugt basiert die LED auf einem Nitridverbindungshalbleiter. "Auf Nitrid-Verbindungshalbleitern basierend" bedeutet im vorliegenden Zusammenhang, dass die aktive Epitaxie-Schichtenfolge oder zumindest eine Schicht davon ein Nitrid-III/V-Verbindungshalbleitermaterial, vorzugsweise AlₙGaₘIn₁₋ₙ₋ₘN umfasst, wobei 0 ≤ n ≤ 1, 0 ≤ m ≤ 1 und n+m ≤ 1. Dabei muss dieses Material nicht zwingend eine mathematisch exakte Zusammensetzung nach obiger Formel aufweisen. Vielmehr kann es einen oder mehrere Dotierstoffe sowie zusätzliche Bestandteile aufweisen, die die charakteristischen physikalischen Eigenschaften des AlₙGaₘIn₁₋ₙ₋ₘN-Materials im Wesentlichen nicht ändern. Der Einfachheit halber beinhaltet obige Formel jedoch nur die wesentlichen Bestandteile des Kristallgitters (Al, Ga, In, N), auch wenn diese teilweise durch geringe Mengen weiterer Stoffe ersetzt sein können.

An der Grenzfläche zwischen der undotierten Schicht und der Schicht aus AlₓGa₁₋ₓN bilden sich Bereiche mit besonders hoher Querleitfähigkeit aus. Die erhöhte Querleitfähigkeit dieser Bereiche lässt sich im Bändermodell derart erklären, dass an dieser Grenzfläche jeweils eine Verbiegung der Bandkante des Leitungsbandes und des Valenzbandes auftritt, die zur Ausbildung einer Potentialmulde führt, in der ein zweidimensionales Elektronengas mit besonders hoher Querleitfähigkeit auftritt.

An der Grenzfläche zwischen der Schicht aus AlₓGa₁₋ₓN und der n-dotierten Schicht kann sich eine negative Polarisationsladung ausbilden, sodass sich eine Barriere für die Elektronen ausbildet, welche sich nachteilig auf den vertikalen Stromtransport in der Stromaufweitungsschicht auswirken könnte. Eine derartige Barriere kann durch einen Konzentrationsgradienten des Aluminiumgehaltes in der Schicht aus AlₓGa₁₋ₓN vermindert werden, ohne dass sich die Ladungsträgerdichte in dem zweidimensionalen Elektronengas signifikant ändert. Zusätzlich vermindern sich dadurch auftretende Verspannungen an der Grenzfläche zwischen der undotierten Schicht und der Schicht aus AlₓGa₁₋ₓN, sowie an der Grenzfläche zwischen der Schicht aus AlₓGa₁₋ₓN und der n-dotierten Schicht.

Bevorzugt weist die Schicht aus AlₓGa₁₋ₓN einen in Richtung zur aktiven Schicht abfallenden Konzentrationsgradienten des Aluminiumgehalts auf.

Durch die so aufgebaute Stromaufweitungsschicht bildet sich an der Grenzfläche zwischen der undotierten Schicht und der Schicht aus AlₓGa₁₋ₓN ein zweidimensionales Elektronengas aus, das die Querleitfähigkeit der Stromaufweitungsschicht erhöht und so eine homogene Bestromung der aktiven Schicht bewirkt. Der Konzentrationsgradient des Aluminiumgehalts der Schicht aus AlₓGa₁₋ₓN, der zur aktiven Schicht hin abfällt, verbessert den vertikalen Stromtransport in der Stromaufweitungsschicht, wodurch eine verbesserte Bestromung der aktiven Schicht erzielt wird.

Bevorzugt weist der Konzentrationsgradient des Aluminiumgehalts einen linearen Abfall auf. Alternativ kann der Konzentrationsgradient des Aluminiumgehalts einen stufenförmigen Abfall aufweisen.

Vorzugsweise weist die Stromaufweitungsschicht mindestens 10 Wiederholungen der Schichtfolge auf, besonders bevorzugt weist die Stromaufweitungsschicht mindestens 20 Wiederholungen der Schichtfolge auf.

Auf diese Weise wird in der Stromaufweitungsschicht eine Vielzahl von Grenzflächen zwischen undotierten Schichten und Schichten aus AlₓGa₁₋ₓN ausgebildet, an denen sich aufgrund der Bandverbiegung jeweils eine Potentialmulde ausbildet, in der ein zweidimensionales Elektronengas mit hoher Querleitfähigkeit auftritt. Die Querleitfähigkeit der gesamten Stromaufweitungsschicht wird dadurch im Vergleich zu einer Stromaufweitungsschicht mit nur einer eingebetteten Schicht aus AlₓGa₁₋ₓN weiter erhöht.

Ferner erhöht sich durch die Vielzahl der Schichten aus AlₓGa₁₋ₓN, die einen Konzentrationsgradienten des Aluminiumgehalts aufweisen, der vertikale Stromtransport in der gesamten Stromaufweitungsschicht, wodurch sich insgesamt die Effizienz der LED erhöht.

Die Schicht aus AlₓGa₁₋ₓN weist bevorzugt eine Dicke zwischen 10 nm und 20 nm auf, beispielsweise eine Dicke von 12 nm, auf.

Für den Aluminiumgehalt x in der Schicht aus AlₓGa₁₋ₓN gilt bevorzugt 0,1 ≤ x ≤ 0,3. Zum Beispiel beträgt der Aluminiumanteil x in der Schicht aus AlₓGa₁₋ₓN an der Grenzfläche zur undotierten Schicht 0,2.

Ein so gewählter Aluminiumgehalt in der Schicht aus AlₓGa₁₋ₓN, der beispielsweise an der Grenzfläche zur undotierten Schicht x = 0,2 beträgt und in Richtung zur aktiven Schicht hin abfällt, führt zu einem optimalen Kompromiss zwischen einer erwünschten Erhöhung der Ladungsträgerdichte im zweidimensionalen Elektronengas und einer unerwünschten Erhöhung der vertikalen Stromtransportbarriere an der Grenzfläche zwischen der Schicht aus AlₓGa₁₋ₓN und der n-dotierten Schicht. Insgesamt erhöht sich die Effizienz der LED mit Vorteil.

Bevorzugt weist die Schicht aus AlₓGa₁₋ₓN zumindest teilweise eine Dotierung auf. Bevorzugt weist die Schicht aus AlₓGa₁₋ₓN zumindest teilweise eine Si-Dotierung auf.

Bevorzugt ist ein der aktiven Schicht zugewandter Teilbereich der Schicht aus AlₓGa₁₋ₓN dotiert und ein der aktiven Schicht abgewandter Teilbereich der Schicht aus AlₓGa₁₋ₓN undotiert.

Die hohe Mobilität der Elektronen im zweidimensionalen Elektronengas wird zum großen Teil auf die verminderte Streuung an ionisierten Dotieratomen zurückgeführt. Das zweidimensionale Elektronengas bildet sich an der Grenzfläche zwischen der undotierten Schicht und der Schicht aus AlₓGa₁₋ₓN aus, wobei das zweidimensionale Elektronengas in der undotierten Schicht konzentriert vorliegt. Durch den der aktiven Schicht abgewandten, undotierten Teilbereich der Schicht aus AlₓGa₁₋ₓN wird die Mobilität der Elektronen im zweidimensionalen Elektronengas weiter erhöht, da sich die Streuung an ionisierten Dotieratomen weiter vermindert. Dadurch verbessern sich weiter die Querleitfähigkeit und die Stromaufweitung, wodurch sich die Effizienz der LED mit Vorteil erhöht.

Weitere Merkmale, Vorteile, bevorzugte Ausgestaltungen und Zweckmäßigkeiten der LED ergeben sich aus den im Folgenden in Verbindung mit den Figuren 1 bis 5 erläuterten Ausführungsbeispielen. Es zeigen:
- Figur 1: einen schematischen Querschnitt eines Ausführungsbeispiels einer erfindungsgemäßen LED,
- Figur 2: einen schematischen Querschnitt eines Ausführungsbeispiels einer Schichtfolge einer Stromaufweitungsschicht einer erfindungsgemäßen LED, und
- Figur 3: einen Verlauf des Aluminiumgehaltes in einem schematischen Querschnitt eines Ausführungsbeispiels einer Stromaufweitungsschicht einer erfindungsgemäßen LED.

Gleiche oder gleich wirkende Bestandteile sind jeweils mit den gleichen Bezugszeichen versehen. Die dargestellten Bestandteile sowie die Größenverhältnisse der Bestandteile untereinander sind nicht als maßstabsgerecht anzusehen.

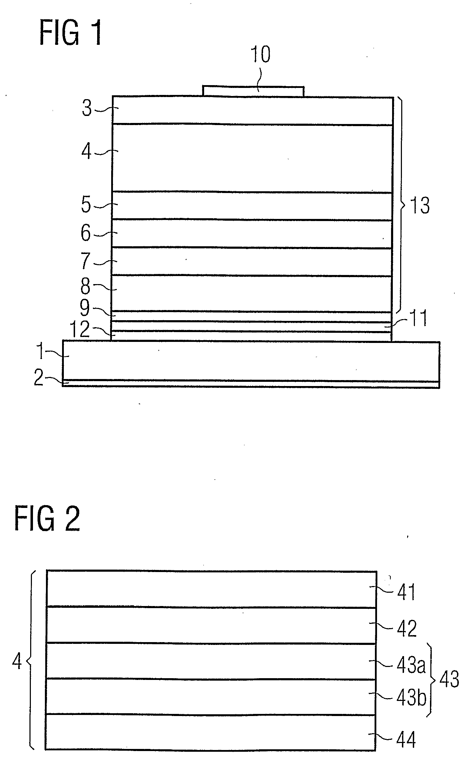

In Figur 1 ist ein schematischer Querschnitt einer erfindungsgemäßen LED mit einem epitaktischen Schichtaufbau 13 dargestellt, wobei die LED vorzugsweise als Dünnfilm-LED ausgeführt ist. Bei einer Dünnfilm-LED ist das Herstellungssubstrat, auf dem der Schichtstapel für die LED hergestellt, insbesondere abgeschieden wurde, bereichsweise oder vollständig entfernt. Das Herstellungssubstrat ist vorzugsweise das Aufwachssubstrat, auf dem der Schichtstapel epitaktisch aufgewachsen ist.

Die Epitaxieschichtenfolge 13 der LED weist eine aktive Schicht 7 auf. Die aktive Schicht 7 der LED umfasst bevorzugt einen pn-Übergang, eine Doppelheterostruktur, eine Mehrfachquantentopfstruktur (MQW) oder besonders bevorzugt eine Einfachquantentopfstruktur (SQW) zur Strahlungserzeugung. Die Bezeichnung Quantentopfstruktur umfasst im Rahmen der Anmeldung insbesondere jegliche Struktur, bei der Ladungsträger durch Einschluss ("confinement") eine Quantisierung ihrer Energiezustände erfahren können. Insbesondere beinhaltet die Bezeichnung Quantentopfstruktur keine Angabe über die Dimensionalität der Quantisierung. Sie umfasst somit unter anderem Quantentröge, Quantendrähte und Quantenpunkte und jede Kombination dieser Strukturen.

Die aktive Schicht 7 ist beispielsweise zwischen einer p-dotierten Halbleiterschicht 8 und einer n-dotierten Übergangsschicht 6 angeordnet. Die p-dotierte Halbleiterschicht 8 der LED ist nicht als einzelne Schicht zu verstehen. Vielmehr kann sich die p-dotierte Halbleiterschicht 8 ebenso aus einer p-dotierten Schichtenfolge zusammensetzen.

An die n-dotierte Übergangsschicht 6 schließt beispielsweise eine n-dotierte Schicht 5 aus beispielsweise GaN an. Auf der n-dotierten Schicht 5 aus GaN ist beispielsweise eine Stromaufweitungsschicht 4 angeordnet, auf der vorzugsweise eine zweite n-dotierte Schicht 3, beispielsweise aus GaN, ausgebildet ist. Auf der zweiten n-dotierte Schicht 3 ist vorzugsweise ein n-Kontakt 10 angeordnet.

Der n-Kontakt 10 kann ein Bondpad und/oder mehrere mit dem Bondpad elektrisch verbundene Kontaktstege umfassen, um eine bessere Stromaufweitung zu erzielen. Durch eine Anordnung mit mehreren mit dem Bondpad elektrisch leitend verbundenen Kontaktstegen kann eine vergleichsweise homogene Stromverteilung in der LED erreicht werden.

Auf einer dem n-Kontakt 10 gegenüberliegenden Seite der Epitaxieschichtenfolge 13 ist die Epitaxieschichtenfolge 13 mittels einer Verbindungsschicht 12, beispielsweise einer Lotschicht, auf einem Träger 1 befestigt. Die Rückseite des Trägers kann beispielsweise mit einer Elektrode 2 versehen sein.

Zur elektrischen Kontaktierung der Epitaxieschichtfolge 13 der LED ist der n-Kontakt 10 und ein p-Kontakt 9 vorgesehen. Der p-Kontakt 9 grenzt an die dem Träger 1 zugewandten Seite der Epitaxieschichtenfolge 13 an, wobei der p-Kontakt 9 vorzugsweise einen ohmschen Kontakt zur angrenzenden Epitaxieschichtfolge 13 herstellt. Der p-Kontakt 9 kann vorzugsweise eine die von der aktiven Schicht 7 emittierte Strahlung reflektierende Schicht sein. Auf diese Weise werden Absorptionsverluste, die beispielsweise innerhalb des Trägers 1 oder in der Verbindungsschicht 12 auftreten könnten, vermindert.

Zwischen dem p-Kontakt 9 und der Verbindungsschicht 12 ist vorzugsweise eine Barriereschicht 11 enthalten, die beispielsweise TiWN enthält. Durch die Barriereschicht 11 wird insbesondere eine Diffusion von Material der Verbindungsschicht 12 in den p-Kontakt 9 verhindert, durch die insbesondere die Reflektion des als Spiegelschicht fungierenden p-Kontakts 9 beeinträchtigt werden könnte.

Die LED basiert bevorzugt auf einem Nitridverbindungshalbleiter. "Auf Nitridverbindungshalbleitern basierend" bedeutet im vorliegenden Zusammenhang, dass die aktive Epitaxieschichtenfolge oder zumindest eine Schicht davon ein Nitrid-III/V-Verbindungshalbleitermaterial, vorzugsweise AlₙGaₘIn₁₋ₙ₋ₘN umfasst, wobei 0 ≤ n ≤ 1, 0 ≤ m ≤ 1 und n + m ≤ 1. Dabei muss dieses Material nicht zwingend eine mathematisch exakte Zusammensetzung nach obiger Formel aufweisen. Vielmehr kann es einen oder mehrere Dotierstoffe sowie zusätzliche Bestandteile aufweisen, die die charakteristischen physikalischen Eigenschaften des AlₙGaₘIn₁₋ₙ₋ₘN-Materials im Wesentlichen nicht ändern. Der Einfachheit halber beinhaltet obige Formel jedoch nur die wesentlichen Bestandteile des Kristallgitters (Al, Ga, In, N), auch wenn diese teilweise durch geringe Mengen weiterer Stoffe ersetzt sein können.

Die Stromaufweitungsschicht 4 befindet sich vorzugsweise auf der n-dotierten Seite der LED. Die Stromaufweitungsschicht 4 ist bevorzugt zwischen zwei n-dotierten Schichten 3, 5 angeordnet, die beispielsweise GaN enthalten und die jeweils bevorzugt mit Si dotiert sind.

Die Stromaufweitungsschicht 4 weist eine sich mehrfach wiederholende Schichtfolge auf. Bevorzugt weist die Stromaufweitungsschicht 4 mindestens 10 Wiederholungen der Schichtfolge auf, besonders bevorzugt weist die Stromaufweitungsschicht 4 mindestens 20 Wiederholungen der Schichtfolge auf.

Ein detaillierter Aufbau eines schematischen Querschnitts einer Schichtfolge einer Stromaufweitungsschicht ist in Figur 2 dargestellt.

Die Schichtfolge weist eine n-dotierte Schicht 41 beispielsweise aus GaN, und eine daran angrenzende undotierte Schicht 42, zum Beispiel aus GaN, auf. An der undotierten Schicht 42 aus GaN schließt sich vorzugsweise eine Schicht 43 aus AlₓGa₁₋ₓN, mit 0 < x < 1, an. Die Schicht 43 aus AlₓGa₁₋ₓN setzt sich bevorzugt aus einem undotierten Teilbereich 43a und aus einem dotierten Teilbereich 43b zusammen, wobei der dotierte Teilbereich 43b der Schicht 43 aus AlₓGa₁₋ₓN der aktiven Schicht 7 zugewandt ist. An die Schicht 43 aus AlₓGa₁₋ₓN schließt sich eine zweite n-dotierte Schicht 44, zum Beispiel aus GaN, an.

Durch die so aufgebaute Stromaufweitungsschicht 4 bildet sich an der Grenzfläche zwischen der undotierten Schicht 42 aus GaN und der Schicht 43 aus AlₓGa₁₋ₓN ein zweidimensionales Elektronengas aus. Durch die Ausbildung eines zweidimensionalen Elektronengases erhöht sich mit Vorteil die Querleitfähigkeit der Stromaufweitungsschicht 4. Die erhöhte Querleitfähigkeit der Stromaufweitungsschicht 4 führt zu einer homogenen Bestromung der aktiven Schicht 7 und erhöht dadurch vorteilhaft die Effizienz der LED.

Die erhöhte Querleitfähigkeit lässt sich im Bändermodell derart erklären, dass an der Grenzfläche jeweils eine Verbiegung der Bandkante des Leitungsbandes und des Valenzbandes auftritt, die zur Ausbildung einer Potentialmulde führt, in der ein zweidimensionales Elektronengas mit besonders hoher Querleitfähigkeit auftritt.

Die Stromaufweitungsschicht 4 weist bevorzugt mindestens 10 Wiederholungen der Schichtfolge, wie sie in Figur 2 dargestellt ist, auf. Besonders bevorzugt weist die Stromaufweitungsschicht 4 mindestens 20 Wiederholungen der Schichtfolge auf.

Auf diese Weise wird in der Stromaufweitungsschicht 4 eine Vielzahl von Grenzflächen zwischen undotierten Schichten 42 aus GaN und Schichten 43 aus AlₓGa₁₋ₓN ausgebildet, an denen sich aufgrund der Bandverbiegung jeweils eine Potentialmulde ausbildet, in der ein zweidimensionales Elektronengas mit hoher Querleitfähigkeit auftritt. Somit erhöht sich die Querleitfähigkeit der gesamten Stromaufweitungsschicht im Vergleich zu einer Stromaufweitungsschicht mit nur einer eingebetteten Schicht 43 aus AlₓGa₁₋ₓN.

Bevorzugt weist die Schicht 43 aus AlₓGa₁₋ₓN in einem Teilbereich 43b eine Dotierung auf. Bevorzugt weist der Teilbereich 43b eine Si-Dotierung auf.

Der Teilbereich 43a der Schicht 43 aus AlₓGa₁₋ₓN, der der aktiven Schicht 7 abgewandt ist, ist bevorzugt undotiert.

Die hohe Mobilität der Elektronen im zweidimensionalen Elektronengas wird zum großen Teil auf die verminderte Streuung an ionisierten Dotieratomen zurückgeführt. Das zweidimensionale Elektronengas bildet sich an der Grenzfläche zwischen der undotierten Schicht 42 aus GaN und der Schicht 43 aus AlₓGa₁₋ₓN aus, wobei das zweidimensionale Elektronengas in der undotierten Schicht 42 aus GaN konzentriert vorliegt. Durch den der aktiven Schicht 7 abgewandten, undotierten Teilbereich 43a der Schicht 43 aus AlₓGa₁₋ₓN wird die Mobilität der Elektronen im zweidimensionalen Elektronengas weiter erhöht, da sich die Streuung an ionisierten Dotieratomen weiter vermindert. Dadurch verbessern sich weiter die Querleitfähigkeit und die Stromaufweitung, wodurch sich die Effizienz der LED mit Vorteil erhöht.

An der Grenzfläche zwischen der Schicht 43 aus AlₓGa₁₋ₓN und der zweiten n-dotierten Schicht 44 aus GaN kann sich eine negative Polarisationsladung ausbilden, sodass eine Barriere für die Elektronen entsteht, welche sich nachteilig auf den vertikalen Stromtransport durch die Stromaufweitungsschicht 4 auswirken könnte. Das Ausbilden dieser Barriere kann durch einen Konzentrationsgradienten des Aluminiumgehaltes in der Schicht 43 aus AlₓGa₁₋ₓN verhindert werden, ohne dass sich die Ladungsträgerdichte in dem zweidimensionalen Elektronengas signifikant ändert. Zusätzlich vermindern sich dadurch auftretende Verspannungen an der Grenzfläche zwischen der undotierten Schicht 42 aus GaN und der Schicht 43 aus AlₓGa₁₋ₓN, sowie an der Grenzfläche zwischen der Schicht 43 aus AlₓGa₁₋ₓN und der zweiten n-dotierten Schicht 44 aus GaN.

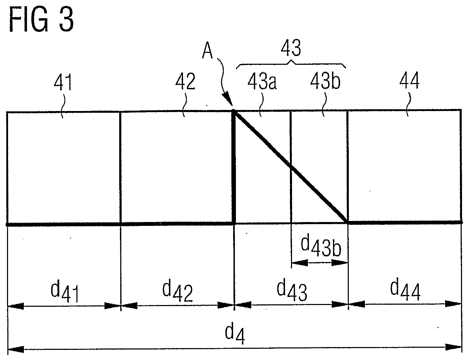

Der Verlauf des Aluminiumgehaltes in einer Schichtfolge der Stromaufweitungsschicht 4 ist in Figur 3 dargestellt. Von links nach rechts gesehen sind in der Figur 3 die n-dotierte Schicht 41 aus GaN, die undotierte Schicht 42 aus GaN, die Schicht 43 aus AlₓGa₁₋ₓN und die zweite n-dotierte Schicht 44 aus GaN dargestellt.

Die Schicht 43 aus AlₓGa₁₋ₓN weist in Richtung zur aktiven Schicht 7 hin einen abfallenden Konzentrationsgradienten des Aluminiumgehalts auf. Bevorzugt weist der Konzentrationsgradient des Aluminiumgehalts einen linearen Abfall auf. Alternativ kann der Konzentrationsgradient des Aluminiumgehalts einen stufenförmigen Abfall aufweisen.

Der Konzentrationsgradient des Aluminiumgehalts der Schicht 43 aus AlₓGa₁₋ₓN verbessert den vertikalen Stromtransport in der Stromaufweitungsschicht 4. Ferner vermindern sich dadurch Verspannungen an der Grenzfläche zwischen den einzelnen Schichten. Das führt zu einer reduzierten Degradation der LED, wodurch sich die Langzeitstabilität und die Lebensdauer der LED mit Vorteil erhöht.

Insgesamt wird durch die so ausgebildete Stromaufweitungsschicht 4 eine hohe Querleitfähigkeit durch das Ausbilden eines zweidimensionalen Elektronengases erzeugt, sowie gleichzeitig der vertikale Stromtransport in der Stromaufweitungsschicht 4 durch den Konzentrationsgradienten des Aluminiumgehalts in der Schicht 43 aus AlₓGa₁₋ₓN optimiert.

Für den Aluminiumgehalt x in der Schicht 43 aus AlₓGa₁₋ₓN gilt bevorzugt 0,1 ≤ x ≤ 0,3. Besonders bevorzugt beträgt der Aluminiumanteil x in der Schicht 43 aus AlₓGa₁₋ₓN an der Grenzfläche A zur undotierten Schicht 42 aus GaN 0,2.

Ein so gewählter Aluminiumgehalt in der Schicht 43 aus AlₓGa₁₋ₓN, der beispielsweise an der Grenzfläche A zur undotierten Schicht 42 aus GaN x = 0,2 beträgt und in Richtung zur aktiven Schicht 7 hin abfällt, führt zu einem optimalen Kompromiss zwischen einer erwünschten Erhöhung der Ladungsträgerdichte im zweidimensionalen Elektronengas und einer unerwünschten Erhöhung der vertikalen Stromtransportbarriere an der Grenzfläche zwischen der Schicht 43 aus AlₓGa₁₋ₓN und der zweiten n-dotierten Schicht 44 aus GaN. Insgesamt erhöht sich die Effizienz der LED mit Vorteil.

Eine Schichtfolge der Stromaufweitungsschicht 4 setzt sich beispielsweise aus folgenden Schichtdicken der einzelnen Schichten zusammen:
Die n-dotierte Schicht 41 aus GaN weist bevorzugt eine Dicke d₄₁ von etwa 15 nm auf. Die undotierte Schicht 42 aus GaN, in der sich vor allem das zweidimensionale Elektronengas ausbildet, weist bevorzugt eine Dicke d₄₂ von etwa 10 nm auf. Die Schicht 43 aus AlₓGa₁₋ₓN weist bevorzugt eine Dicke von d₄₃ von etwa 12 nm auf, wobei der dotierte Teilbereich 43b eine Dicke d_{43b} von etwa 8 nm aufweist. Daran schließt sich die zweite n-dotierte Schicht 44 aus GaN mit einer bevorzugten Dicke d₄₄ von etwa 13 nm an. Insgesamt ergibt sich somit für eine Schichtfolge der Stromaufweitungsschicht 4 eine bevorzugte Dicke d₄ von etwa 50 nm. Dadurch ergibt sich für eine Stromaufweitungsschicht 4, die sich bevorzugt aus 20 Schichtfolgen zusammensetzt, eine Schichtdicke von etwa 1 µm.

Die LED kann zusätzlich zu den oben genannten Schichten beispielsweise Buffer-Schichten, Barriereschichten und/oder Übergangsschichten enthalten. Ferner können die einzelnen Schichten der LED unterschiedliche Dotierungen aufweisen.

## Patentansprüche

1. LED, die eine strahlungsemittierende aktive Schicht (7), einen n-Kontakt (10), einen p-Kontakt (9) und eine Stromaufweitungsschicht (4) aufweist, wobei
- die Stromaufweitungsschicht (4) zwischen der aktiven Schicht (7) und dem n-Kontakt (10) angeordnet ist,
- die Stromaufweitungsschicht (4) eine sich mehrfach wiederholende Schichtfolge aufweist,
- die Schichtfolge mindestens eine n-dotierte Schicht (44), eine undotierte Schicht (42) und eine Schicht aus AlₓGa₁₋ₓN (43), mit 0 < x < 1, aufweist, und
- die Schicht aus AlₓGa₁₋ₓN (43) einen Konzentrationsgradienten des Al-Gehalts aufweist,
**dadurch gekennzeichnet, dass**
- die Schicht aus AlₓGa₁₋ₓN (43) zwischen der undotierten Schicht (42) und der n-dotierten Schicht (44) angeordnet ist.

2. LED gemäß Anspruch 1,
wobei die Schicht aus AlₓGa₁₋ₓN (43) einen in Richtung zur aktiven Schicht (7) abfallenden Konzentrationsgradienten des Al-Gehalts aufweist.

3. LED gemäß Anspruch 2,
wobei der Konzentrationsgradient des Al-Gehalts einen linearen Abfall aufweist.

4. LED gemäß Anspruch 2,
wobei der Konzentrationsgradient des Al-Gehalts einen stufenförmigen Abfall aufweist.

5. LED gemäß einem der vorhergehenden Ansprüche,
wobei die Stromaufweitungsschicht (4) mehr als zehn Wiederholungen der Schichtfolge aufweist.

6. LED gemäß einem der vorhergehenden Ansprüche,
wobei die Schicht aus AlₓGa₁₋ₓN (43) eine Dicke zwischen 10 nm und 20 nm aufweist.

7. LED gemäß einem der vorhergehenden Ansprüche,
wobei für den Aluminiumanteil x in der Schicht aus AlₓGa₁₋ₓN (43) 0,1 ≤ x ≤ 0,3, gilt.

8. LED gemäß einem der vorhergehenden Ansprüche,
wobei die Schicht aus AlₓGa₁₋ₓN (43) zumindest teilweise eine Dotierung aufweist.

9. LED gemäß Anspruch 8,
wobei die Schicht aus AlₓGa₁₋ₓN (43) zumindest teilweise eine Si-Dotierung aufweist.

10. LED gemäß einem der Ansprüche 8 oder 9,
wobei ein der aktiven Schicht (7) zugewandter Teilbereich (43b) der Schicht aus AlₓGa₁₋ₓN (43) dotiert ist.

11. LED gemäß einem der vorhergehenden Ansprüche,
wobei ein der aktiven Schicht (7) abgewandter Teilbereich (43a) der Schicht aus AlₓGa₁₋ₓN (43) undotiert ist.

## Claims

1. An LED having a radiation-emitting active layer (7), an n-type contact (10), a p-type contact (9) and a current spreading layer (4) wherein
- the current spreading layer (4) is arranged between the active layer (7) and the n-type contact (10),
- the current spreading layer (4) has a multiply repeating layer sequence,
- the layer sequence has at least one n-doped layer (44), an undoped layer (42) and a layer composed of AlₓGa₁₋ₓN (43), where 0 < x < 1, and
- the layer composed of AlₓGa₁₋ₓN (43) has a concentration gradient of the Al content,
**characterized in that**
- the layer composed of AlₓGa₁₋ₓN (43) is arranged between the undoped layer (42) and the n-doped layer (44).

2. The LED as claimed in claim 1,
wherein the layer composed of AlₓGa₁₋ₓN (43) has a concentration gradient of the Al content that decreases in a direction toward the active layer (7).

3. The LED as claimed in claim 2,
wherein the concentration gradient of the Al content has a linear decrease.

4. The LED as claimed in claim 2,
wherein the concentration gradient of the Al content has a stepped decrease.

5. The LED as claimed in any of the preceding claims,
wherein the current spreading layer (4) has more than ten repetitions of the layer sequence.

6. The LED as claimed in any of the preceding claims, wherein the layer composed of AlₓGa₁₋ₓN (43) has a thickness of between 10 nm and 20 nm.

7. The LED as claimed in any of the preceding claims, wherein 0.1 ≤ x ≤ 0.3 holds true for the aluminum proportion x in the layer composed of AlₓGa₁₋ₓN (43) .

8. The LED as claimed in any of the preceding claims, wherein the layer composed of AlₓGa₁₋ₓN (43) at least partly has a doping.

9. The LED as claimed in claim 8,
wherein the layer composed of AlₓGa₁₋ₓN (43) at least partly has an Si doping.

10. The LED as claimed in either of claims 8 and 9,
wherein a partial region (43b) of the layer composed of AlₓGa₁₋ₓN (43) which faces the active layer (7) is doped.

11. The LED as claimed in the preceding claims,
wherein a partial region (43a) of the layer composed of AlₓGa₁₋ₓN (43) which is remote from the active layer (7) is undoped.

## Revendications

1. DEL qui présente une couche active émettrice d'un rayonnement (7), un contact n (10), un contact p (9) et une couche d'élargissement de courant (4),
- la couche d'élargissement de courant (4) étant agencée entre la couche active (7) et le contact n (10),
- la couche d'élargissement de courant (4) présentant une succession de couches se répétant plusieurs fois,
- la succession de couches présentant au moins une couche dopée n (44), une couche non dopée (42) et une couche en AlₓGa₁₋ₓN (43), où 0 < x < 1, et
- la couche en AlₓGa₁₋ₓN (43) présentant un gradient de concentration de la teneur en Al,
**caractérisée en ce que**
- la couche en AlₓGa₁₋ₓN (43) est agencée entre la couche non dopée (42) et la couche dopée n (44).

2. DEL selon la revendication 1,
la couche en AlₓGa₁₋ₓN (43) présentant un gradient de concentration de la teneur en Al qui diminue en direction de la couche active (7).

3. DEL selon la revendication 2,
le gradient de concentration de la teneur en Al présentant une baisse linéaire.

4. DEL selon la revendication 2,
le gradient de concentration de la teneur en Al présentant une baisse par paliers.

5. DEL selon l'une quelconque des revendications précédentes,
la couche d'élargissement de courant (4) présentant plus de dix répétitions de la succession de couches.

6. DEL selon l'une quelconque des revendications précédentes,
la couche en AlₓGa₁₋ₓN (43) présentant une épaisseur comprise entre 10 nm et 20 nm.

7. DEL selon l'une quelconque des revendications précédentes,
où pour la teneur en aluminium x dans la couche de AlₓGa₁₋ₓN (43) 0,1 ≤ x ≤ x ≤ 0,3, s'applique.

8. DEL selon l'une quelconque des revendications précédentes,
la couche en AlₓGa₁₋ₓN (43) présentant au moins partiellement un dopage.

9. DEL selon la revendication 8,
la couche en AlₓGa₁₋ₓN (43) présentant au moins partiellement un dopage Si.

10. DEL selon l'une quelconque des revendications 8 ou 9,
une zone partielle (43b) de la couche en AlₓGa₁₋ₓN (43), tournée vers la couche active (7), étant dopée.

11. DEL selon l'une quelconque des revendications précédentes,
une zone partielle (43a) de la couche en AlₓGa₁₋ₓN (43), tournée dans la direction opposée à la couche active (7), étant non dopée.
